# EUROPEAN PATENT SPECIFICATION

(11) **EP 2 312 663 B1**
(45) Date of publication and mention of the grant of the patent: **15.10.2014**
(21) Application number: 09173429.3
(22) Date of filing: 19.10.2009
(51) Int. Cl.: H01L 51/54, C09K 11/06

(54) **Organic electronic device comprising an organic semiconducting material**
Organische elektronische Vorrichtung mit einem organischen Halbleitermaterial
Dispositif électronique organique comportant un matériau semi-conducteur organique

(43) Date of publication of application: 20.04.2011
(73) Proprietor: Novaled AG, 01307 Dresden (DE)
(72) Inventor: Fadhel, Omrane, 01099 Dresden (DE); Pretsch, Ramona, 01097 Dresden (DE)
(74) Representative: Scholz, Volker

(56) References cited:
- US-A- 2 441 019
- US-A1- 2008 122 344
- WU D ET AL: "Synthesis and self-assembly of dibenzo[jk,mn]naphtho[2,1,8-fgh]theben idinium derivates" TETRAHEDRON, ELSEVIER SCIENCE PUBLISHERS, AMSTERDAM, NL, vol. 64, no. 50, 8 December 2008 (2008-12-08), pages 11379-11386, XP025624852 ISSN: 0040-4020 [retrieved on 2008-08-27]
- J. L. KROPP, J. J. LOU: "The Fluorescense and Phosphorescence of 1,2;5,6 - Dibenzacridine and 1,2;7,8 - Dibenzacridine in Glassy and Liquid Solution" THE JOURNAL OF PHYSICAL CHEMISTRY, vol. 74, no. 22, 1970, pages 3953-3959, XP002575066

## Description

The present invention relates to a semiconducting layer, preferably an organic electronic device, comprising an organic semiconducting material.

### Field of the invention

Conjugated organic compounds have different applications. One important field comprises organic semiconductors. Organic semiconductors can be used to fabricate simple electronic components e.g. resistors, diodes, field effect transistors, and also optoelectronic components like organic light emitting devices (e.g. OLED), and many others. The industrial and economical significance of the organic semiconductors and their devices is reflected in the increased number of devices using organic semiconducting active layers and the increasing industry focus on the subject.

A simple OLED is demonstrated in US4356429A. There, between conductive electrodes, two semiconductive organic layers are brought together: one transporting holes and the other one transporting electrons. The recombination of holes and electrons forms excitons in one or both of the organic layers, the excitons are eventually emitted following the spin statistics. Excitons with triplet spin can also be harvested by using the materials and techniques described in EP 1705727. More elaborated OLEDs are described in EP 1804309 and US2008182129.

Conjugated organic compounds can be small molecules, for instance monomers, or oligomers, polymers, copolymers, copolymers of conjugated and non-conjugated blocks, completely or partially cross-linked layers, aggregate structures, or brush like structures. A device made with different types of compounds, in different layers or mixed together, for example with polymer and small molecule layers, is also called a polymer - small molecule hybrid device.

Organic electronic semiconductors can be used in organic electronic devices, and in organic-inorganic hybrid devices.

Despite the large electronic gap, usually up to 3 eV, formed between the highest occupied molecular orbital (HOMO) and the lowest unoccupied molecular orbital (LUMO) of the molecule, it is normally still low enough such that both positive and negative charge carriers can be injected by special electrodes. Typical organic semiconducting compounds may have a gap that is still high enough so that the compounds are optically active.

Organic field effect transistors are explained, for example, in US7026643, US2005146262 and US2008230776. The resistance of a semiconductive layer that is contacted by two electrodes (source and drain) can be controlled by the voltage that is applied to the gate. The gate is displaced on an insulator that is displaced parallel in contact to the semiconductive layer. Various geometries can be used, such as bottom gate (on the substrate), top gate (on the opposite side of the semiconductive layer relative to the substrate) or on both sides. Many different arrangements of layers can be used such as bipolar layers, injection layer, insulating layer between electrode and semiconductive layer to lower the off current, etc.

US 2008/0122344 A1 relates to an organic light-emitting compound, an organic light-emitting device comprising the same and a method of manufacturing the light-emitting device. The light-emitting compound is a N-aryl substituted pyrrol which is substituted in alpha and beta positions by different aromatic ring systems.

US 2,441,019 A relates to a light-polarizing material and the process of its preparation. The disclosed light-polarizing material comprises a suspension of optically oriented, asymmetric crystals in a light-transmitting suspension medium. The said crystals comprise a periodide of dibenzacridine.

The publication of Wu et al., Tetrahedron, 2008, 64, 11379-11386 relates to a novel synthetic method toward nitrogen-containing positively charged dibenzo[jk,mn]naphtho[2,1,8-fgh]thebenidinium (TBNT) salts. Various TBNT salts with different alkyl and alky phenyl chains were synthesized in a two-step method. Further, the self-assembling behavior of two alkylated TBNT salts was studied.

The publication of Kropp et al., J. Phys. Chem., 1970, 74(22), 3953-3959, relates to 1,2,5,6-dibenzacridine and 1,2,7,8-dibenzacridine and its absorption and emission properties. In this work the singlet and triplet absorptions spectra and fluorescence and phosphorescence spectra have been determined as well as the fluorescence and phosphorescence intensities and lifetimes.

### Background of the invention

Different functional layers in different organic semiconductor devices request a variety of special characteristics.

For instance organic thin-film transistors (OTFTs) need high mobility materials in their active channel. Transparent circuits, such as transparent OTFTs require that the high mobility organic material also comprises a wide electronic band gap; the electric injection of holes and / or electrons must be still provided.

OLEDs require transparent transport layers, with high conductivity. The transparency is necessary in those opto-electric devices to avoid non desired absorption of the light. These so called "window" materials can be used as transport layers, exciton or charge blocking layers. The thickness of the layers made with the window materials is used to adjust the micro cavity of the OLEDs in such a way that the outcoupled emission of the OLED is a maximum. The non-optically active layers of all kinds of semiconductor devices can be exchanged for win-dow materials in order to fabricate fully transparent components and circuits (e.g US20060033115).

The functionality and nomenclature of the layers are typical as used in the field. Further explanation can be found in US2006244370.

Electronic devices also need high stability towards temperature, meaning that the intrinsic properties of the amorphous organic semiconducting materials, such as triphenyl amine derivatives, or phenantronine derivatives, must include a high glass transition temperature (Tg) and high temperature stability in the device.

The conductivity can be, for example, measured by the so-called 2-point or 4-point-method. Here, contacts of a conductive material, such as gold or indium-tin-oxide, are disposed on a substrate. Then, the thin film to be examined is applied onto the substrate, so that the contacts are covered by the thin film. After applying a voltage to the contacts the current is measured. From the geometry of the contacts and the thickness of the sample the resistance and therefore the conductivity of the thin film material can be determined. The four point or two point method give the same conductivity values for doped layers since the doped layers grant a good ohmic contact.

The temperature stability can be also measured with that method in that the (undoped or doped) layer is heated stepwise, and after a waiting period the conductivity is measured. The maximum temperature, which can be applied to the layer without loosing the desired semiconducting properties, is then the temperature just before the conductivity breaks down, For example, a doped layer can be heated on the substrate with two electrodes, as disclosed above, in steps of 1°C, wherein after each step there is a waiting period of 10 seconds. Then the conductivity is measured. The conductivity changes with temperature and breaks down abruptly at a particular temperature. The temperature stability is therefore the temperature up to which the conductivity does not break down abruptly. The measurement is performed in vacuum.

The properties of the many different used materials can be described by the position of their highest occupied molecular orbital energy level (HOMO, synonym of ionization potential), and the lowest unoccupied molecular orbital energy level (LUMO, synonym of electron aftinity).

A method to determine the ionization potentials (IP) is the ultraviolet photo spectroscopy (UPS). It is usual to measure the ionization potential for solid state materials; however, it is also possible to measure the IP in the gas phase. Both values are differentiated by their solid state effects, which are, for example the polarization energy of the holes that are created during the photo ionization process. A typical value for the polarization energy is approximately 1 eV, but larger discrepancies of the values can also occur. The IP is related to beginning of the photoemission spectra in the region of the large kinetic energy of the photoelectrons, i.e. the energy of the most weakly bounded electrons. A related method to UPS, the inverted photo electron spectroscopy (IPES) can be used to determine the electron affinity (EA). However, this method is less common. Electrochemical measurements in solution are an alternative to the determination of solid state oxidation (Eox) and reduction (Ered) potential. An adequate method is for example the cyclo-voltammetry. Empiric methods for the extraction of the solid state ionization potentials are known from the literature. There are no known empiric equations for the conversion of reduction potentials into electron affinities. The reason for that is the difficulty of the determination of the electron affinity. Therefore, a simple rule is used very often: IP=4.8 eV+ e*Eox (vs. Ferrocen/Ferrocenium) and EA=4.8eV +e*Ered (vs. Ferrocen/Ferrocenium) respectively (see B.W. Andrade, Org. Electron. 6, 11 (2005) and Refs. 25-28 therein). Processes are known for the correction of the electrochemical potentials in the case other reference electrodes or other redox pairs are used (see A.J. Bard, L.R. Faulkner, "Electrochemical Methods: Fundamentals and Applications", Wiley, 2. Ausgabe 2000). The information about the influence of the solution used can be found in N.G. Connelly et al., Chem. Rev. 96, 877 (1996). It is usual, even if not exactly correct to use the terms "energy of the HOMO" E(HOMO) and "energy of the LUMO" E(LUMO) respectively as synonyms for the ionization energy and electron affinity (Koopmans Theorem). It has to be taken in consideration, that the ionization potentials and the electron affinities are given in such a way that a larger value represents a stronger binding of a released or respectively of an absorbed electron. The energy scale of the molecular orbitals (HOMO, LUMO) is opposed to this. Therefore, in a rough approximation, is valid: IP=-E(HOMO) and EA=E(LUMO). The given potentials correspond to the solid-state potentials. Hole transport layers, including the respective blockers, mostly have HOMO in the range from -4.5 to -5.5 eV (below the vacuum level) and LUMO in the range of -1.5 eV to -3 eV. The HOMO levels of the emitter materials are in the range of -5 eV to -6.5 eV, and the LUMO in the range from -2 to -3 eV. Electron transport materials, including their respective blockers, have their HOMO in a range of -5.5 eV to -6.8 eV and LUMO in the range of -2.3 eV to -3.3 eV. The work function of the contact materials is around -4 to -5 eV for the anode and -3 to -4.5 eV for the cathode.

The performance characteristics of (opto)electronic multilayered components are determined by the ability of the layers to transport the charge carriers, amongst others. In the case of light-emitting diodes, the ohmic losses in the charge transport layers during operation are associated with their conductivity. The conductivity directly influences the operating voltage required and also determines the thermal load of the component. Furthermore, depending on the charge carrier concentration in the organic layers, bending of the band in the vicinity of a metal contact results which simplifies the injection of charge carriers and can therefore reduce the contact resistance.

By electrically doping hole transport layers with a suitable acceptor material (p-doping) or electron transport layers with a donor material (n-doping), respectively, the density of charge carriers in organic solids (and therefore the conductivity) can be increased substantially. Additionally, analogous to the experience with inorganic semiconductors, applications can be anticipated which are precisely based on the use of p- and n-doped layers in a component and otherwise would be not conceivable. The use of doped charge-carrier transport layers (p-doping of the hole transport layer by admixture of acceptor-like molecules, n-doping of the electron transport layer by admixture of donor-like molecules) in organic light-emitting diodes is described in US2008203406 and US 5,093,698.

US2008227979 discloses in detail the doping of organic transport materials, also called matrix, with inorganic and with organic dopants. Basically, an effective electronic transfer occurs from the dopant to the matrix increasing the Fermi level of the matrix. For an efficient transfer in a p-doping case, the LUMO energy level of the dopant must be more negative than the HOMO energy level of the matrix or at least slightly more positive, not more than 0.5 eV, to the HOMO energy level of the matrix. For the n-doping case, the HOMO energy level of the dopant must be more positive than the LUMO energy level of the matrix or at least slightly more negative, not lower than 0.5 eV, to the LUMO energy level of the matrix. It is furthermore desired that the energy level difference for energy transfer from dopant to matrix is smaller than + 0.3 eV.

The dopant donor is a molecule or a neutral radical or combination thereof with a HOMO energy level (ionization potential in solid state) more positive than -3.3 eV, preferably more positive than -2.8 eV, more preferably more positive than -2.6 eV and its respective gas phase ionization potential is more positive than -4.3 eV, preferably more positive than -3.8 eV, more preferably more positive than -3.6 eV. The HOMO of the donor can be estimated by cyclo-voltammetric measurements. An alternative way to measure the reduction potential is to measure the cation of the donor salt. The donor has to exhibit an oxidation potential that is smaller than or equal to -1.5 V vs Fc / Fc+ (Ferrum/Ferrocenium redox-pair), preferably smaller than -1.5 V, more preferably smaller than or equal to approximately -2.0 V, even more preferably smaller than or equal to -2.2 V. The molar mass of the donor is in a range between 100 and 2000 g/mol, preferably in a range from 200 and 1000 g / mol. The molar doping concentration is in the range of 1:10000 (dopant molecule : matrix molecule) and 1:2, preferably between 1:100 and 1:5, more preferably between 1:100 and 1:10. In individual cases doping concentrations larger than 1:2 are applied, e.g. if large conductivities are required. The donor can be created by a precursor during the layer forming (deposition) process or during a subsequent process of layer formation (see DE 10307125.3). The above given value of the HOMO level of the donor refers to the resulting molecule or molecule radical.

A dopant acceptor is a molecule or a neutral radical or combination thereof with a LUMO level more negative than -4,5 eV, preferably more negative than -4.8 eV, more preferably more negative than -5.04 eV. The LUMO of the acceptor can be estimated by cyclo-voltammetric measurements. The acceptor has to exhibit a reduction potential that is larger than or equal to approximately -0.3 V vs Fc / Fc+ (Ferrum/Ferrocenium redox-pair), preferably larger than or equal to 0.0 V, preferably larger than or equal to 0.24 V. The molar mass of the aceptor is preferably in the range of 100 to 2000 g / mol, more preferably between 200 and 1000 g / mol, and even more preferably between 300 g/mol and 2000 g/mol. The molar doping concentration is in the range of 1:10000 (dopant molecule : matrix molecule) and 1:2, preferably between 1:100 and 1:5, more preferably between 1:100 and 1:10. In individual cases doping concentrations larger than 1:2 are applied, e.g. if large conductivities are required. The acceptor can be created by a precursor during the layer forming (deposition) process or during a subsequent process of layer formation. The above given value of the LUMO level of the acceptor refers to the resulting molecule or molecule radical.

Typical examples of doped hole transport materials are: copperphthalocyanine (CuPc), which HOMO level is approximately -5.2 eV, doped with tetrafluoro-tetracyanoquinonedimethane (F4TCNQ), which LUMO level is about -5.2 eV; zincphthalocyanine (ZnPc) (HOMO = -5.2 eV) doped with F4TCNQ; a-NPD (N,N'-Bis(naphthalen-1-yl)-N,N'-bis(phenyl)-benzidine) doped with F4TCNQ.

Typical examples of doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis ( 1,3,4,6,7,8 - hexahydro - 2H - pyrimido [ 1,2 - a] pyrimidinato) ditungsten (II) (W(hpp)₄); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF).

By using the term doping it is meant electrical doping as explained above. This doping can also be called redox-doping or charge transfer doping. It is known that the doping increases the density of charge carriers of a semiconducting matrix towards the charge carrier density of the undoped matrix. An electrically doped semiconductor layer also has an increased effective mobility in comparison with the undoped semiconductor matrix.

There is a technical challenge to provide electron transport materials (ETM) and emitter host (EMH) materials that have a sufficiently low laying LUMO level so that they can be doped, and still have a high enough laying LUMO level which can efficiently transfer charge to emitter host (in case of an ETM) and transfer energy to the emitter dopant (in case of EMH). The limitation for high laying LUMO level of the ETL is given by the dopability, since the n-dopants with very high HOMO tend to be unstable; also the injection is difficult for very high LUMO of the ETL.

### Summary of the invention

It is an object of the present invention to provide a semiconducting layer, preferably an organic electronic device, comprising a specific class of functional materials which can be utilized as organic semiconducting materials to overcome the drawbacks of the prior art. Especially, an organic electronic device shall be provided comprising transparent organic semiconducting materials which are additionally thermally stable and/or dopable. Further, the organic electronic device shall comprise semiconducting materials which can be synthesized without any difficulties.

This object is achieved by a semiconducting layer, more preferably an organic electronic device comprising an organic semiconducting material comprising at least one compound according to the following formula: 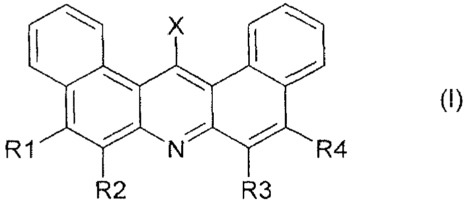
wherein R₁₋₄ are independently selected from H, halogen, CN, substituted or unsubstituted C₁-C₂₀-alkyl or heteroalkyl, C₆-C₂₀-aryl or C₅-C₂₀-heteroaryl, C₁-C₂₀-alkoxy or C₆-C₂₀-aryloxy,
X is selected from substituted or unsubstituted C₆-C₂₀-aryl or C₅-C₂₀-heteroaryl 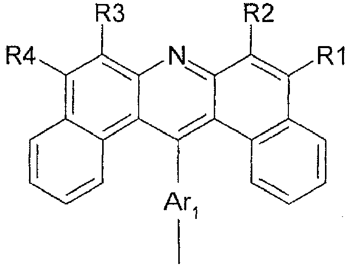 or, 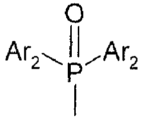
wherein Ar₁ and Ar₂ are aromatic moieties.

Preferably X, Ar₁, Ar₂ are independently selected from C₆-C₂₀-aryl or C₅-C₂₀-heteroaryl.

Preferably X and/or Ar₂ is selected from

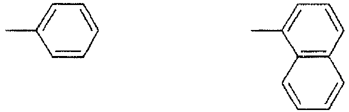

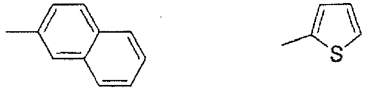

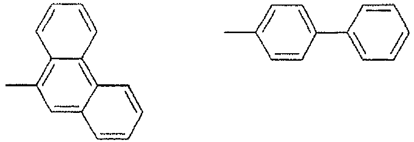

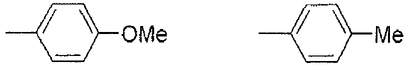

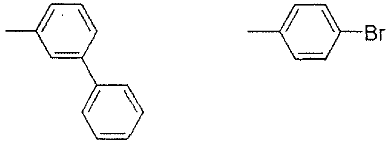

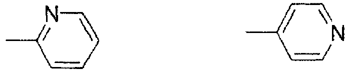

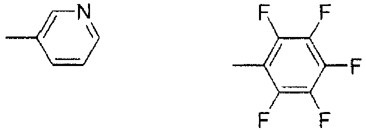

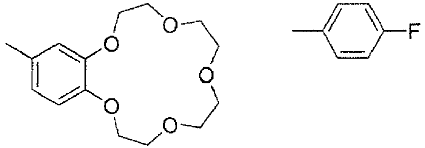

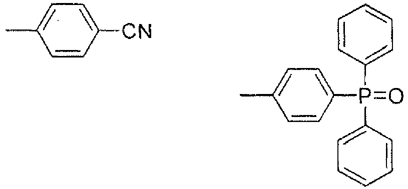

In a further preferred embodiment, Ar₁ is selected from

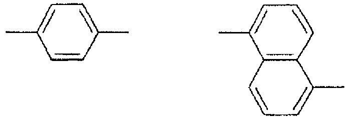

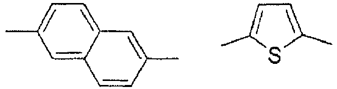

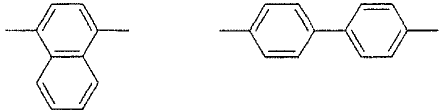

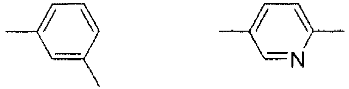

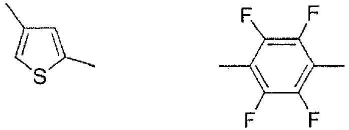

More preferably Ar₁ is selected from C₆-aryl or C₅-C₆-heteroaryl, such as thiophen.

Even preferred, the device has a layered structure and at least one layer comprises at least one compound according to formula (I) as defined above.

Most preferred, the organic semiconducting material is doped by an n-dopant.

The organic semiconducting material may be doped by an organic n-dopant which dopant has HOMO energy level which is more positive than -3.3 eV.

It is preferred that the device is an electronic, optoelectronic or electroluminescent device having an electronically functionally effect region, wherein the electronically effective region comprises at least one compound according to formula (I) as defined above.

The device may be preferably an organic light-emitting diode, a field-effect transistor, a sensor, a photodetector, an organic thin-film transistor, an organic integrated circuit, an organic light-emitting transistor, a light-emitting electrochemical cell or an organic laser diode.

Preferred compounds to be utilized in the organic electronic device are, amongst others, compounds according to the following formula:

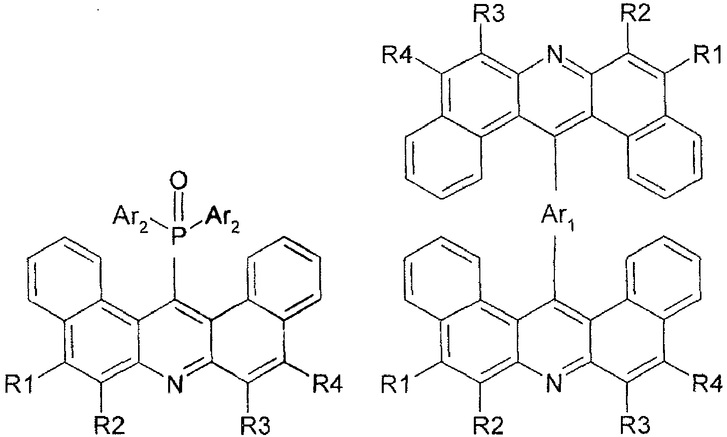

Most preferred structures of the compound can be as follows:

| | |
|---|---|
| 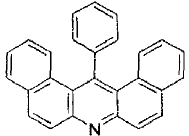 | 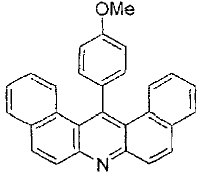 |
| Structure 1 | Structure 2 |
| 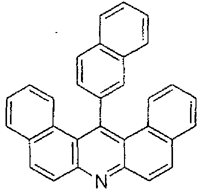 | 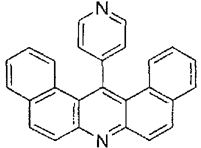 |
| Structure 3 | Structure |
| 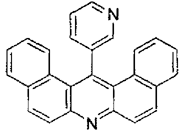 | 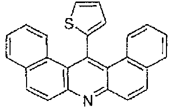 |
| Structure 5 | Structure 6 |
| 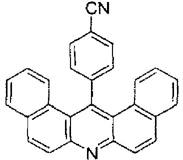 | 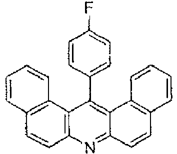 |
| Structure 7 | Structure 8 |
| 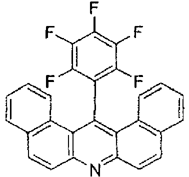 | 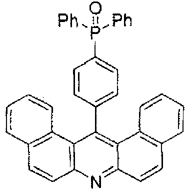 |
| Structure 9 | Structure 10 |
| 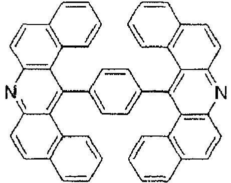 | 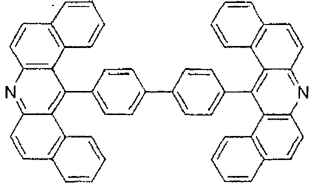 |
| Structure 11 | Structure 12 |
| 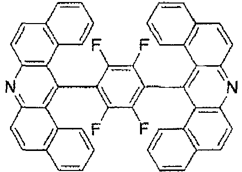 | 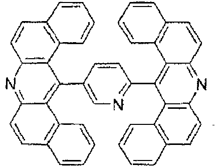 |
| Structure 13 | Structure 14 |
| 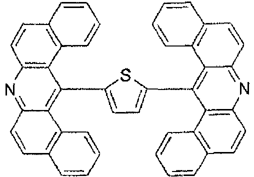 | 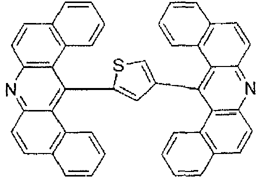 |
| Structure 16 | Structure 17 |

An organic n-dopant can be, for example, selected from the dopants as disclosed in EP 2002492 A1, US 2007252140 or US 2009212280.

According to the invention is also an organic electronic device comprising an organic semiconducting material comprising at least one organic matrix material which is optionally doped with at least one dopant, wherein the matrix material comprises a compound according to formula (I).

In a light-emitting diode the compounds can be used in electron transport layers, which might be optionally doped. The compounds can be also used in light-emitting diodes in interlayers such as hole blocking layers.

According to the invention, the compounds are preferably used in the electron transport layer and not as main compound of the emitter layer, preferably they are not used in the emitter layer at all.

According to the invention, especially a window semiconducting organic material is provided for the device that can be electrically doped achieving a high conductivity while it remains highly transparent in the visible spectra and has a high thermal stability.

According to the invention, also an organic field-effect transistor can be provided comprising at least one compound according to formula (I) for use in a transport layer, in other words, in the semiconducting channel layer. An organic field effect transistor may also comprise at least one compound as disclosed as electronically inert buffer layer, when no charge is injected due to high potential barrier. An organic field effect transistor may also comprise at least one compound as disclosed as doped injection layer.

The compounds used in this invention according to formula (I) can be used in OLEDs in electron transport layers as a neat layer, or as a doped layer in combination with a redox dopant. The compounds can also be used in mixture with other electron transport materials, with other hole transport materials or with other functional materials such as emitter dopants. The compounds can be used as hole blocking layers. Advantageous effects are seen over the prior art since the materials have a higher glass transition temperature compared to materials described in the prior art, such as in DE 10 2007 012 794 or EP 07 400 033.2 (not published yet).

The use of the compounds according to formula (I) provides high thermal stability, especially due to high glass transition temperature, a good LUMO position for organic light-emitting devices, good dopability, conductivity and charge carrier mobility, high transparency, and easy synthesis. Further, preparation of these compounds can be conducted in a very cost-effective manner. Finally, it can be pointed out that the synthesis of such compounds offers a high flexibility to change independently the R and X, Ar₁ or Ar₂ groups which opens access to more complex compounds and therefore to different physical/chemical properties resulting in a fine tuning thereof.

It was surprisingly found that especially the thermal stability of doped layers comprising a compound as disclosed can be significantly increased in the devices according to the present invention comprising matrix material. Especially, a glass transition temperature of over 100°C was achieved with the compounds shown in the examples. The combination of such a high glass temperature, the wide gap and the dopability make those compounds to have a high industrial relevance for use in organic electronic devices.

Additional features and advantages of the invention can be taken from the following detailed description of preferred embodiments, together with the drawings as attached.

### Brief description of the drawings

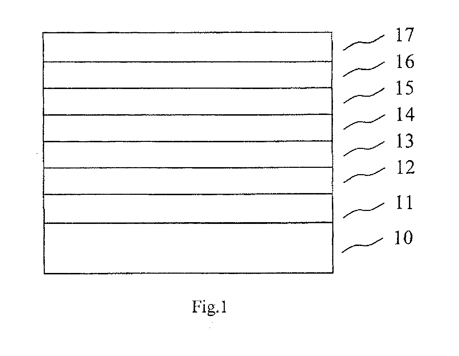

Fig. 1 shows a cross section of a typical exemplary small molecule OLED.

The organic electronic device of the present invention may be an organic light emitting diode. Fig. 1 shows a typical layer structure of an organic light emitting diode. The layers are disposed on a substrate (10) in the following order: anode (11), p-doped hole transport layer (12), electron blocking layer (13), emission layer (14), hole blocking layer (15), n-electron transport layer (16), and cathode (17). Two or more layers can collapse into a smaller number of layers if properties can be combined. Inverted structure and multiple stacked OLEDs are also well known in the field. The emission layer is usually composed by an emitter matrix material and an emitter dopant; this layer can be also composed by several other layers to generate light with a broad spectrum combining several emitters, for example, to generate white light.

### Examples

### General synthesis method

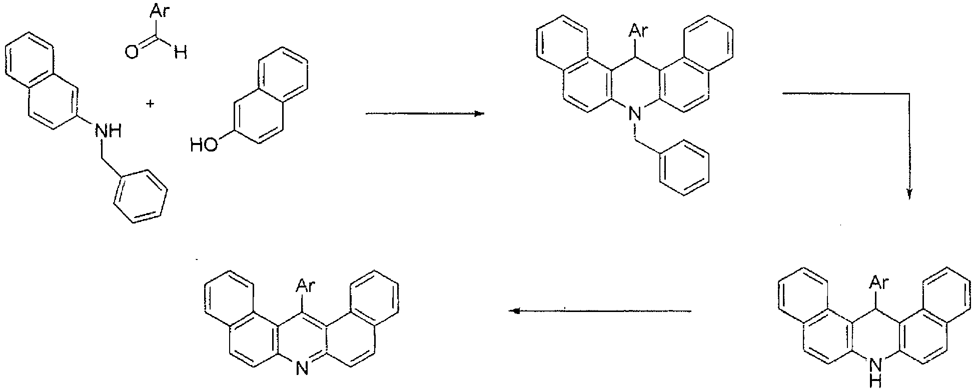

### Example 1

Synthesis of

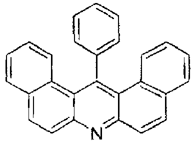

First step: Synthesis of 7-benzyl-14-phenyl-7,14-dihydrodibenzo[a,j]acridine (1). All manipulations were carried out in air, without any further purification of commercial solvents/chemical.s.

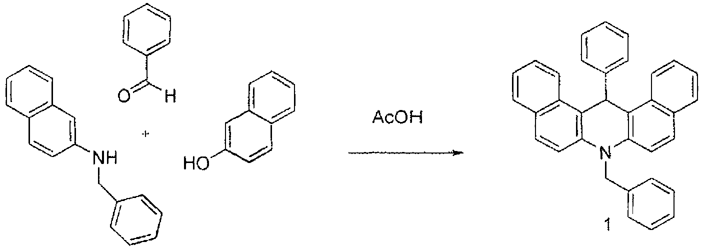

N-Benzyl-2-naphthylamine (1g, 4.29mmol) and 2-naphthol (0.62g, 4.30mmol are introduced in a flask, together with benzaldehyde (0.48 mL, 4.75 mmol) and acetic acid (15 mL). The mixture is refluxed for 17h and cooled down to room temperature.The precipitate is filtered, then washed with water and dried in a vacuum oven.
Yield: 1.18g (62%)
NMR: 1H NMR (500 MHz, CD2Cl2) δ 8.50 (d, J = 8.6, 2H), 7.78 (d, J = 7.9, 2H), 7.67 (d, J = 9.0, 2H), 7.59 (ddd, J = 1.2, 6.9, 8.4, 2H), 7.41 - 7.19 (m, 11H), 7.11 (dd, J = 4.8, 10.5, 2H), 7.01 (t, J = 7.3, 1H), 6.90 (s, 1H), 5.49 (s, 2H).

Second step: Synthesis of 14-phenyl-7,14-dihydrodibenzo[a,j]acridine (2). All manipulations were carried out in air, without any further purification of commercial solvents/chemicals.

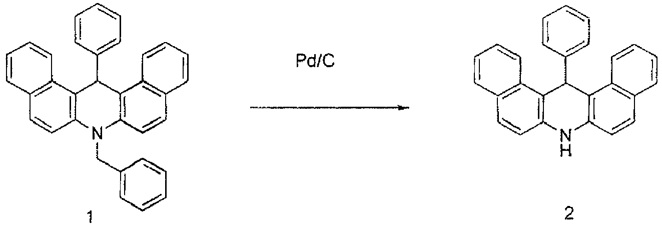

1 (4g, 8.9 mmol) and Pd/C (4g) are introduced in a flask and acetic acid (90mL) and ammonium formiate (4g, 63.4 mmol) are then poured in, the mixture is then refluxed for 20h. The suspension is then filtered to remove Pd/C and washed with chloroform. 100mL water is then added and the water phase is neutralised with a 2M NaOH solution. The organic phase is then isolated and the water phase is extracted another time with chloroform. The organic phases are dried over MgSO4, and the volatile materials were evaporated.
Yield : 2.58g (81%)

Third step: Synthesis of 14-phenyldibenzo[a,j]acridine (3). All manipulations were carried out in air, without any further purification of commercial solvents/chemicals.

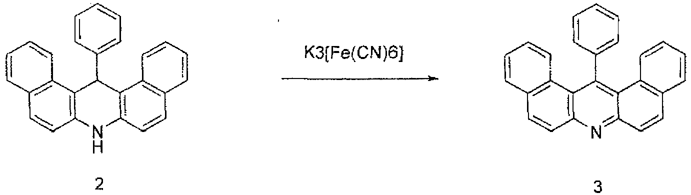

**2** (2.58g, 7.21 mmol) was dissolved in 100mL chloroform. Potassium iron hexacyanate (4.5g, 13.7 mmol) dissolved in 100 mL potassium hydroxide 2 M solution. After 4h stirring at room temperature, were the phases separated, the organic phase washed with water and dried over MgSO4. The volatile materials were then evaporated.
Yield: 2.33g (91%)
1H NMR (500 MHz, CD2Cl2) δ 8.02 - 7.94 (m, 4H), 7.86 (dd, J = 1.2, 7.8, 2H), 7.71 (ddd, J = 5.9, 11.0, 25.9, 3H), 7.45 (dd, J = 7.3, 8.4, 4H), 7.20 (d, J = 8.7, 2H), 7.05 (ddd, J = 1.5, 7.0, 8.6, 2H).

### Example 2

Synthesis of

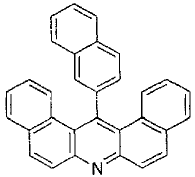

First step: Synthesis of 7-benzyl-14-(naphthalen-2-yl)-7,14-dihydrodibenzo[a,j]acridine (4). All manipulations were carried out in air, without any further purification of commercial solvents/chemicals.

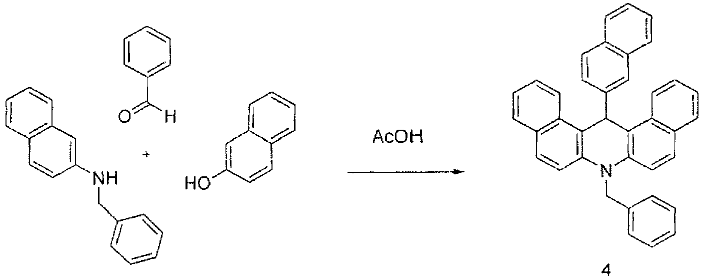

N-Benzyl-2-naphthylamine (5g, 21.4mmol) and 2-naphthol (3.09g, 21.4mmol) are introduced in a flask, together with 2-naphthaldehyde (3.36g, 21.5 mmol) and acetic acid (15 mL). The mixture is refluxed for 30h and cooled down to room temperature. The precipitate is filtered, then washed with water and dried in a vacuum oven. The mixture was purified by column chromatography on silica gel (Hexanes / DCM).
Yield: 3.45g (33%)

Second step: Synthesis of 14-(naphthalen-2-yl)-7,14-dihydrodibenzo[a,j]acridine (5). All manipulations were carried out in air, without any further purification of commercial solvents/chemicals.

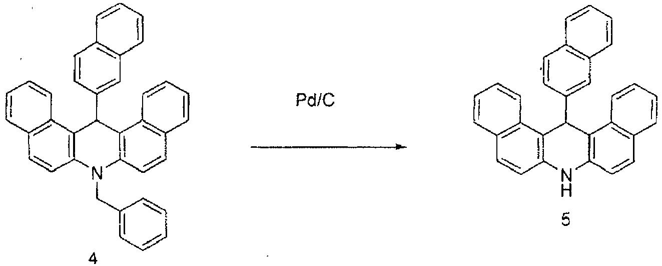

4 (3.45g, 6.93 mmol) and Pd/C (3.46g) are introduced in a flask and acetic acid (80mL) and ammonium formiate (3g, 47.6 mmol) are then poured in, the mixture is then refluxed for 48h. The suspension is then filtered to remove Pd/C and washed with chloroform. 100mL water is then added and the water phase is neutralised with a 2M NaOH solution. The organic phase is then isolated and the water phase is extracted another time with chloroform. The organic phases are dried over MgSO4, and the volatile materials were evaporated.
Yield: 2.25g (80%)

Third step: Synthesis of 14-(naphthalen-2-yl)dibenzo[a,j]acridine (6). All manipulations were carried out in air, without any further purification of commercial solvents/chemicals.

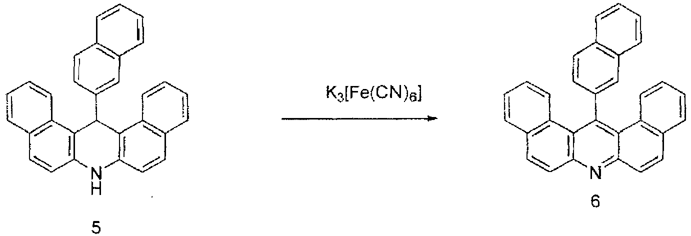

**5** (2.24g, 5.50 mmol) was dissolved in 120mL chloroform. Potassium iron hexacyanate (4.5g, 13.7 mmol) dissolved in 100 mL potassium hydroxide 2 M solution. After 5h stirring at room temperature, were the phases separated, the organic phase washed with water and dried over MgSO4. The volatile materials were then evaporated, and the crude product was recrystallized in chloroform.
Yield: 1g (45%)
1H NMR (500 MHz, CD2Cl2) δ 8.21 (d, J = 8.3, 1H), 8.10 (d, J = 8.3, 1H), 8.00 (q, J = 9.0, 4H), 7.91 (s, 1H), 7.88 - 7.82 (m, 2H), 7.79 (d, J = 8.1, 1H), 7.66 (dd, J = 6.6, 13.7, 1H), 7.64 (s, 1H), 7.58 (t, J = 7.0, 1H), 7.38 (t, J = 7.4, 2H), 7.13 (d, J = 8.7, 2H), 6.84 (ddd, J = 1.4, 7.1, 8.6, 2H).

### Example 3

Synthesis of

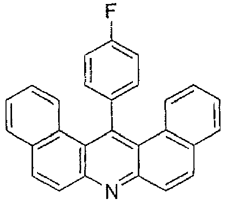

This example was conducted as example 1, except that the aldehyde used in the first step was 4-fluorobenzaldehyde.

### Example 4

Synthesis of

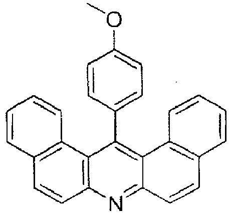

This example was conducted as example 1, except that the aldehyde used in the first step was 4-methoxybenzaldehyde.

### Example 5

Synthesis of

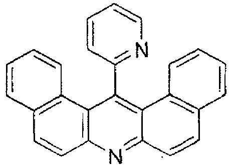

This example was conducted as example 1, except that the aldehyde used in the first step was picolinaldehyde.

### Example 6

Synthesis of

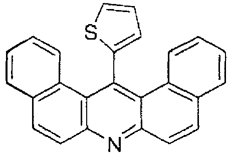

This example was conducted as example 1, except that the aldehyde used in the first step was thiophene-2-carbaldehyde.

### Example 7

Synthesis of

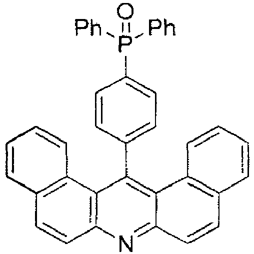

This example was conducted as example 1, except that the aldehyde used in the first step was 4-(diphenylphosphoryl)benzaldehyde. 4-(diphenylphosphoryl)benzaldehyde was produced according to Schiemenz and Kaack, Liebigs Ann. Chem. 1973, paragraphs 2 and 3 on pp. 1487 and Z. Chem., 30. Jg. (1980) Heft 7 paragraph 2 on pp. 259 ("4-Diphenylphosphinyl-benzaldehyd") which paragraphs are incorporated herein as reference.

### Example 8

Synthesis of

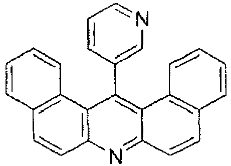

This example was conducted as example 1, except that the aldehyde used in the first step was nicotinaldehyde.

### Example of conductive layers

The conductivity of a doped layer consisting of material of example 3 doped with 5% of W(hpp)₄ (Tetrakis (1,3,4,6,7,8-Hexahydro-2H-pyrimido[1,2-a] pyrimidinato) ditungsten (II)) was measured at room temperature and was 1.24x10⁻⁴ S/cm.

The conductivity of a doped layer consisting of material of example 7 doped with 5% of W(hpp)4 was measured at room temperature and was 7x10⁻⁸ S/cm.

The conductivity of a doped layer consisting of material of example 8 doped with 5% of W(hpp)4 was measured at room temperature and was 2.08x10⁻⁵ S/cm.

The conductivity of a doped layer consisting of material of example 5 doped with 5% of W(hpp)4 was measured at room temperature and was 4.15x10⁻⁶ S/cm.

### Example of an OLED

The compounds from examples 1-8 were successfully employed as electron transport materials in OLEDs. An exemplary device structure is given below.

### Device 1

An OLED was fabricated with the following procedure: A glass substrate coated with ITO (90 nm thick, pre-patterned) was cleaned in organic solvents in conventional ultra-sound. Afterwards the substrate was treated with ozone plasma for 5 minutes. After the cleaning, the substrate was transferred to vacuum. The organic layers were deposited in high vacuum (base pressure lower than 10⁻³ Pa) by conventional VTE (Vacuum thermal evaporation). The deposited area was defined by a shadow mask, keeping some area of the ITO surface free so that an electrical contact for the measurements could (later on) be established. The organic layer sequence over the ITO layer is: 50 nm thick NPD layer doped with F4TCNQ; 10 nm thick non-doped NPD layer, 20 nm blue emitter host layer doped with a fluorescent emitter; 10 nm ETL (5), 60 nm ETL (5) doped with W(hpp)₄ (5% in weight). A 100 nm aluminum layer was deposited as cathode. The OLED reached 1000 cd/m² at 2.9 V.

The features disclosed in the foregoing description and in the claims may, both separately and in any combination thereof, be material for realizing the invention in diverse forms thereof.

## Claims

1. Organic electronic device comprising an organic semiconducting material comprising at least one compound according to the following formula: 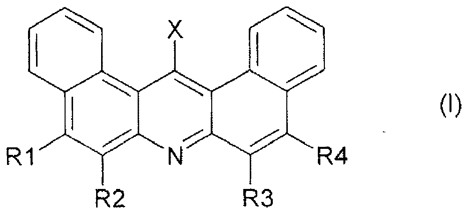
wherein R₁₋₄ are independently selected from H, halogen, CN, substituted or unsubstituted C₁-C₂₀-alkyl or heteroalkyl, C₆-C₂₀-aryl or C₅-C₂₀-heteroaryl, C₁-C₂₀-alkoxy or C₆-C₂₀-aryloxy,
X is selected from substituted or unsubstituted C₆-C₂₀-aryl or C₅-C₂₀-heteroaryl, 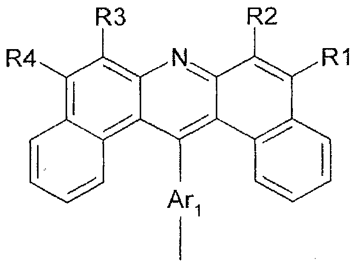 or, 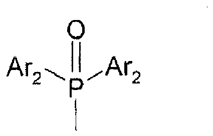
wherein Ar₁ and Ar₂ are aromatic moieties independently selected from C₆-C₂₀-aryl or C₅-C₂₀-heteroaryl.

2. Organic electronic device according to claim 1, wherein X and/or Ar₂ is selected from

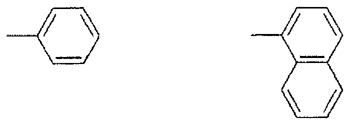

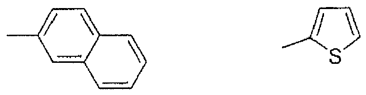

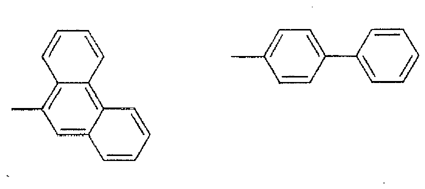

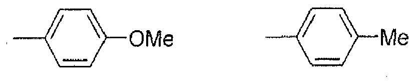

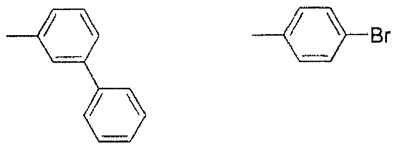

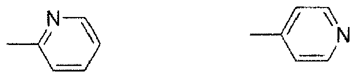

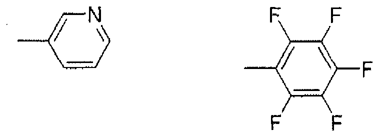

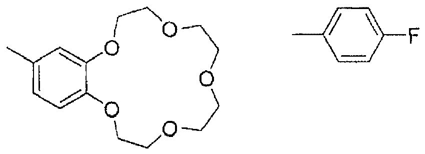

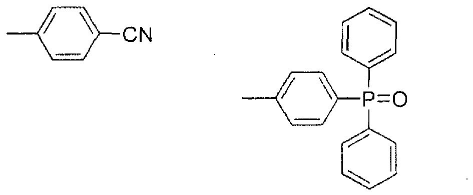

3. Organic electronic device according to any of the preceding claims, wherein Ar₁ is selected from

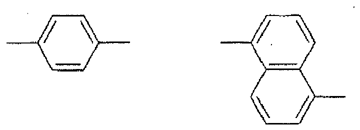

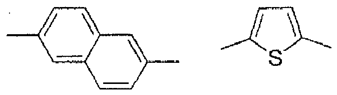

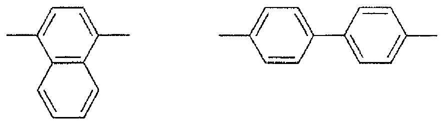

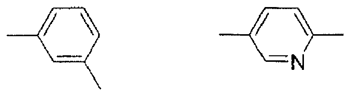

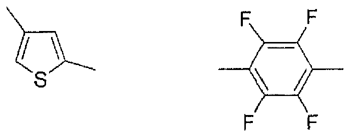

4. Organic electronic device according to any of the preceding claims, wherein the device has a layered structure and at least one layer comprises at least one compound according to formula (I) as defined in claim 1.

5. Organic electronic device according to any of the preceding claims, wherein the organic semiconducting material is doped by an n-dopant.

6. Organic electronic device according to claim 5, wherein the organic semiconducting material is doped by an organic n-dopant which dopant has HOMO energy level which is more positive than -3.3 eV.

7. Organic electronic device according to claim 1, wherein the device is an electronic, optoelectronic or electroluminescent device having an electronically functionally effect region, wherein the electronically effective region comprises at least one compound according to formula (1) as defined in claim 1.

8. Organic electronic device according to any of the preceding claims, wherein the device is an organic light-emitting diode, a field-effect transistor, a sensor, a photodetector, an organic thin-film transistor, an organic integrated circuit, an organic light-emitting transistor, a light-emitting electrochemical cell or an organic laser diode.

## Patentansprüche

1. Organische elektronische Vorrichtung, die ein organisches halbleitendes Material umfasst, das zumindest eine Verbindung entsprechend der folgenden Formel umfasst: 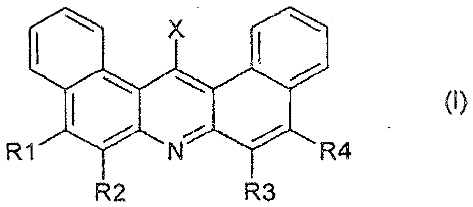
wobei R₁₋₄ unabhängig voneinander ausgewählt sind aus H, Halogen, CN, substituiertem oder unsubstituiertem C₁-C₂₀-Alkyl oder Heteroalkyl, C₆-C₂₀-Aryl oder C₅-C₂₀-Heteroaryl, C₁-C₂₀-Alkoxy oder C₆-C₂₀-Aryloxy,
X ausgewählt ist aus substituiertem oder unsubstituiertem C₆-C₂₀-Aryl oder C₅-C₂₀-Heteroaryl, 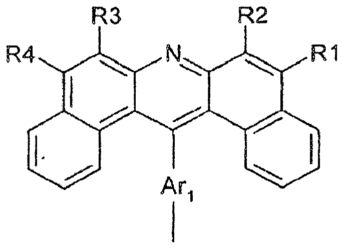 oder 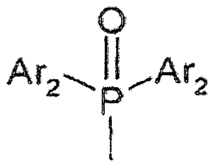
wobei Ar₁ und Ar₂ aromatische Teile sind, die unabhängig voneinander ausgewählt sind aus C₆-C₂₀-Aryl oder C₅-C₂₀-Heteroaryl.

2. Organische elektronische Vorrichtung nach Anspruch 1, wobei X und/or Ar₂ ausgewählt sind aus

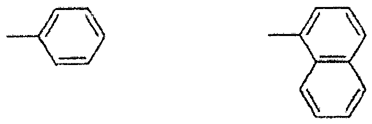

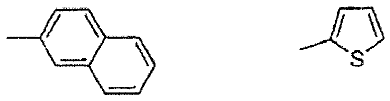

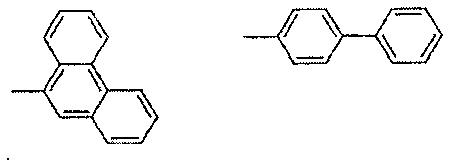

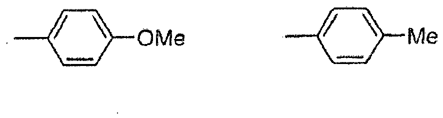

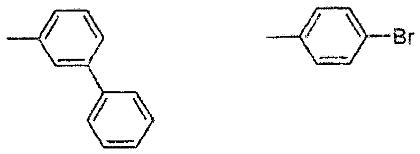

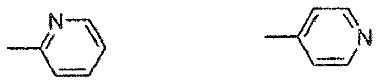

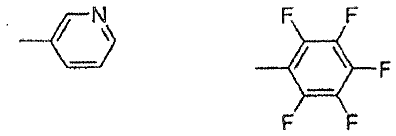

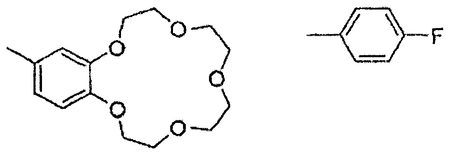

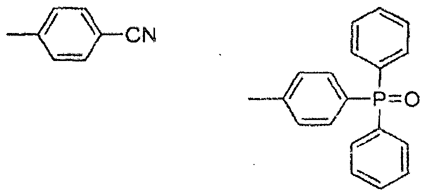

3. Organische elektronische Vorrichtung nach einem der vorangehenden Ansprüche, wobei Ar₁ ausgewählt ist aus

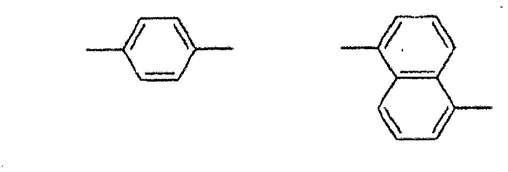

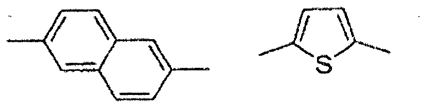

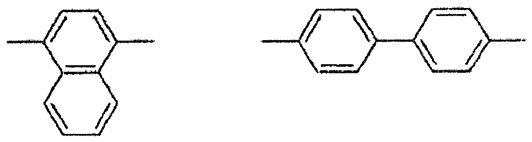

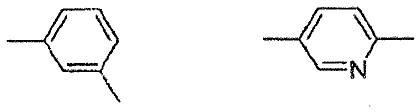

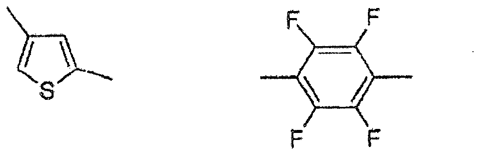

4. Organische elektronische Vorrichtung nach einem der vorangehenden Ansprüche, wobei die Vorrichtung eine Schichtstruktur hat und zumindest eine Schicht zumindest eine Verbindung entsprechend der Formel (I), wie in Anspruch 1 definiert, umfasst.

5. Organische elektronische Vorrichtung nach einem der vorangehenden Ansprüche, wobei das organische halbleitende Material mit einem n-Dotanden dotiert ist.

6. Organische elektronische Vorrichtung nach Anspruch 5, wobei das organische halbleitende Material mit einem organischen n-Dotanden dotiert ist, wobei der Dotand ein HOMO-Energie-Niveau hat, das positiver als -3,3 eV ist.

7. Organische elektronische Vorrichtung nach Anspruch 1, wobei die Vorrichtung eine elektronische, optoelektronische oder elektrolumineszente Vorrichtung ist, die einen elektronischen funktionellen Wirkungsbereich hat, wobei der elektronische Wirkungsbereich zumindest eine Verbindung entsprechend der Formel (I), wie in Anspruch 1 definiert, umfasst.

8. Organische elektronische Vorrichtung nach einem der vorangehenden Ansprüche, wobei die Vorrichtung eine organische lichtemittierende Diode, ein Feldeffekttransistor, ein Sensor, ein Photodetektor, ein organischer Dünnfilmtransistor, ein organischer integrierter Schaltkreis, ein organischer lichtemittierender Transistor, eine lichtemittierende elektrochemische Zelle oder eine organische Laseriode ist.

## Revendications

1. Dispositif électronique organique comprenant un matériau semi-conducteur organique comprenant au moins un composé selon la formule suivante : 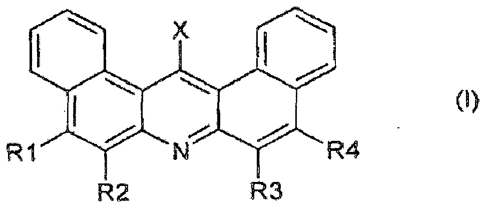
R₁ à R₄ étant indépendamment choisis parmi H, l'halogéne, CN, l'alkyle ou l'hétéroalkyle en C₁ à C₂₀ substitué ou non substitué, l'aryle en C₆ à C₂₀ ou l'hétéroaryle en C₅ à C₂₀, l'alcoxy en C₁ à C₂₀ ou l'aryloxy en C₆ à C₂₀,
X étant choisi parmi l'aryle en C₆ à C₂₀ ou l'hétéroaryle en C₅ à C₂₀ substitué ou non substitué, 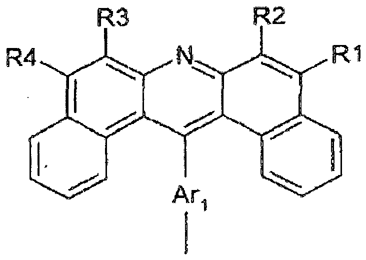 ou, 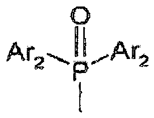
Ar₁ et Ar₂ étant des fragments aromatiques indépendamment choisis parmi l'aryle en C₆ à C₂₀ ou l'hétéroaryle en C₅ à C₂₀.

2. Dispositif électronique organique selon la revendication 1, X et/ou Ar₂ étant choisis parmi

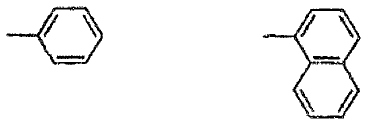

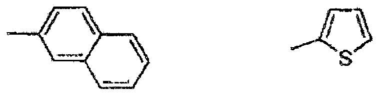

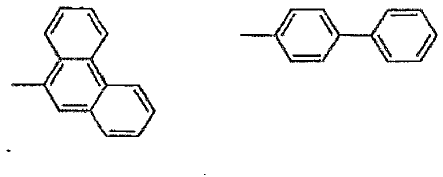

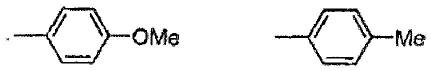

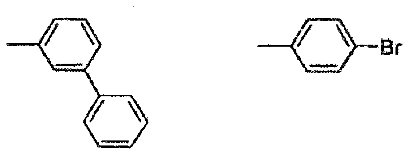

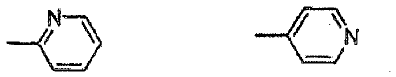

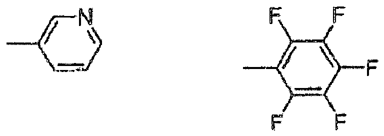

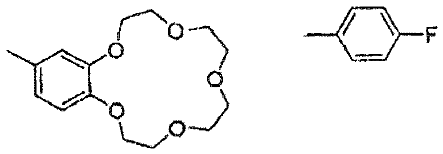

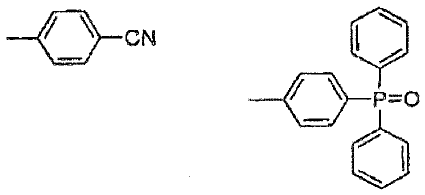

3. Dispositif électronique organique selon l'une quelconque des revendications précédentes, Ar₁ étant choisi parmi

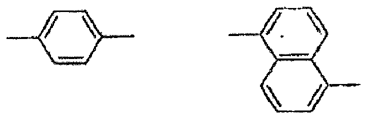

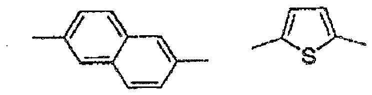

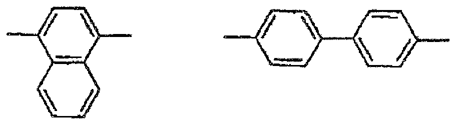

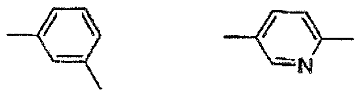

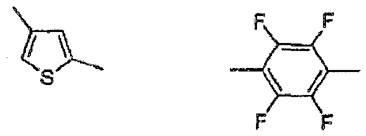

4. Dispositif électronique organique selon l'une quelconque des revendications précédentes, le dispositif ayant une structure stratifiée et au moins une couche comprenant au moins un composé selon la formule (I) tel que défini dans la revendication 1.

5. Dispositif électronique organique selon l'une quelconque des revendications précédentes, le matériau semi-conducteur organique étant dopé par un dopant de type n.

6. Dispositif électronique organique selon la revendication 5, le matériau semi-conducteur organique étant dopé par un dopant organique de type n, lequel dopant a un niveau énergétique HOMO plus positif que -3,3 eV.

7. Dispositif électronique organique selon la revendication 1, le dispositif étant un dispositif électronique, optoélectronique ou électroluminescent ayant une section électroniquement effective d'un point de vue fonctionnel, la section électroniquement effective comprenant au moins un composé selon la formule (I) tel que défini dans la revendication 1.

8. Dispositif électronique organique selon l'une quelconque des revendications précédentes, le dispositif étant une diode électroluminescente organique, un transistor à effet de champ, un capteur, un photodétecteur, un transistor organique en couches minces, un circuit intégré organique, un transistor électroluminescent organique, une pile électrochimique électroluminescente ou une diode laser organique.
